Europäisches Patentamt

European Patent Office

Office européen des brevets

(19)

(11) Publication number: **0 034 851**
**B1**

(12)

# EUROPEAN PATENT SPECIFICATION

(45) Date of publication of patent specification: **05.06.85**

(51) Int. Cl.⁴: **H 03 H 9/64**

(21) Application number: **81200147.7**

(22) Date of filing: **06.02.81**

(54) Acoustic wave bandpass electrical filters.

(30) Priority: **21.02.80 GB 8005926**
**19.01.81 GB 8101527**

(43) Date of publication of application:
**02.09.81 Bulletin 81/35**

(45) Publication of the grant of the patent:
**05.06.85 Bulletin 85/23**

(84) Designated Contracting States:
**DE FR GB**

(56) References cited:
**FR-A-2 290 785**

**APPLIED PHYSICS LETTERS, vol. 30, no. 8, 15th
April 1977 New York, US L.P. SOLIE: "A SAW
bandpass filter technique using a fanned
multistrip coupler", pages 374-376**

**PROCEEDINGS OF THE IEE-F, vol. 127 no. 2,
April 1980 Stevenage, GB J.M. DEACON: "SAW
filters: some case histories", pages 107-117**

**ELECTRONICS LETTERS, vol. 16, no. 10, 9th
May 1980 London, GB R.J. MURRAY et al.:
"Harmonic suppression in surface acoustic-
wave devices using jogged multistrip
couplers", pages 356-358**

(73) Proprietor: **PHILIPS ELECTRONIC AND
ASSOCIATED INDUSTRIES LIMITED
Arundel Great Court 8 Arundel Street
London WC2R 3DT (GB)**
(84) **GB**

(73) Proprietor: **N.V. Philips' Gloeilampenfabrieken
Groenewoudseweg 1
NL-5621 BA Eindhoven (NL)**
(84) **DE FR**

(72) Inventor: **Schofield, John
c/o Mullard Limited New Road
Mitcham Surrey CR4 4XY (GB)**
Inventor: **Murray, Robert John
c/o Philips Research Laboratories
Redhill Surrey RH1 5HA (GB)**
Inventor: **Mitchell, Richard Frank c/o Philips
Industries
Arundel Great Court 8 Arundel Street
London WC2R 3DT (GB)**

(74) Representative: **Boxall, Robin John et al
Philips Electronic and Associated Ind. Ltd.
Patent Department Mullard House Torrington
Place
London WC1E 7HD (GB)**

Courier Press, Leamington Spa, England.

## Description

The present invention relates to acoustic wave bandpass electrical filters, and in particular to such devices including a track changing multistrip array arranged between input and output transducers on a substrate able to propagate acoustic waves at a surface thereof.

Surface acoustic wave (SAW) bandpass electrical filters are well known which consist of an input interdigital transducer and an output interdigital transducer with an interposed track changing multistrip array on a high coupling piezoelectric substrate, e.g. Y—Z lithium niobate. The combined amplitude-frequency response of the two transducers has a passband which is substantially the desired passband of the filter. The major advantage of the multistrip array in these filters is that it provides relative suppression of bulk wave spuriae, and a further advantage is that it allows apodization weighting of both transducers.

The amplitude-frequency response of each transducer in these filters has a fundamental passband and further passbands at particular harmonics dependent on the sampling configuration of the transducer, that is to say the centre-to-centre separation period and the mark-to-space ratio of the transducer electrodes. If the input and output transducers have different sampling configurations then this may result in suppression of certain of these harmonic passbands in the combined amplitude-frequency response of the filter; this suppression will not occur if the two transducers have the same sampling configuration. An interdigital transducer having electrodes with a centre-to-centre separation period of a quarter wavelength of the surface acoustic waves at the centre frequency of the fundamental passband, known as a double or split electrode transducer, and with an electrode mark-to-space ratio of one-to-one has, as the nearest further passband to the fundamental passband, a third harmonic passband response which is of nearly equal amplitude to that of the fundamental passband. A major advantage of the double electrode configuration transducer is that interactions within the transducer which cause undesired ripples in the amplitude-frequency response are minimised, and for this reason it is common to use this configuration for both the input and output transducers. However, the unsuppressed third harmonic response resulting from this use can be a significant disadvantage in certain filter applications. An interdigital transducer having electrodes with a centre-to-centre separation period of a half wavelength of surface acoustic waves at the centre frequency of the fundamental passband, known as a single electrode transducer, and with an electrode mark-to-space ratio of one-to-one has as the nearest further passband to the fundamental passband, a fifth harmonic passband response. An advantage of the single electrode configuration transducer is that for a given minimum realisable width of the electrodes the fundamental passband is at twice the frequency of a double electrode configuration transducer. However, the unsuppressed fifth harmonic response resulting from this use may be a significant disadvantage in certain filter applications.

An object of the invention is to enable the above-mentioned disadvantages of unsuppressed harmonic responses to be overcome, and the basic idea of the invention is to adapt the geometry of a track changing multistrip array arranged between input and output transducers on a substrate in such a way, by division of the array into sub-groups whose separation is different in the input track with respect to the output track, that a stopband is provided in the amplitude-frequency response of the multistrip array which suppresses and undesired passband of the transducers.

According to the invention there is provided an acoustic wave bandpass electrical filter including a substrate able to propagate acoustic waves at a surface thereof, input transducing means arranged to launch acoustic wave energy along a first propagation track at said surface, output transducing means arranged to receive acoustic wave energy from a second propagation track at said surface, and electrical coupling means arranged to receive acoustic wave energy from the input transducing means in the first track and to relaunch at least part of that energy as acoustic wave energy towards the output transducing means in the second track, in which the combined amplitude-frequency response of the input and output transducing means has a first passband which is substantially the desired main passband of the filter and at least one undesired further passband at a respective odd harmonic frequency with respect to said first passband, and in which the coupling means consists of an array of conducting strips across the first track and an array of conducting strips across the second track, the conducting strips of each array being discrete parallel strips electrically insulated from each other and strips of the two arrays being electrically connected in pairs with each pair consisting of one strip from each array, the strips of the coupling means being arranged in one group or in a plurality of groups so that, for example, adjacent said groups are spaced from one another along the first and second tracks by respective distances which differ by $\lambda_0$, where $\lambda_0$ is the acoustic wavelength of the centre frequency $f_0$ of the desired first passband, characterised in that the or each group consists of a corresponding set of at least two sub-groups, each sub-group consisting of strips from both arrays, and in that for each set, the respective effective adjacent sub-group spacings along the first and second tracks differ by an amount which is substantially less than $\lambda_0$ and is a proper fraction of the acoustic wavelength of a predetermined frequency which substantially coincides with the centre frequency of a selected said undesired further passband, and the number and relative composition of the sub-groups forming the set are selected in relation to said proper fraction so as to cause the acoustic wave energy relaunched thereby towards the output transducer to combine in a mutually cancelling phase and amplitude relationship at said predetermined frequency so as to provide a stopband in the amplitude-frequency response of the coupling means which suppresses said selected undesired further passband while maintaining the desired main passband response of the filter.

The or each said group may consist of two sub-groups; this provides a simple construction of the coupling means. Another possibility is that the or each said group may consist of three sub-groups; this provides a more complex construction of the coupling means but also provides the possibility of a wider stopband in the response of the coupling means. The sampling configuration of the transducers forming the input and output transducing means may be wholly double electrode configuration such that said first passband is a fundamental passband and the nearest said further passband is a corresponding third harmonic passband, in which case the selected said further passband which is suppressed may be said third harmonic passband. Another possibility is that the sampling configuration of the transducers forming the input and output transducing means may be a wholly single electrode configuration such that said first passband is a fundamental passband and the nearest said further passband is a corresponding fifth harmonic passband, in which case the selected said further passband which is supressed may be said fifth harmonic passband.

It may be advantageous in a filter according to the invention to have the multistrip array additionally provide a further stopband where suppression is not achieved by the above stated division of the array into sub-groups. This may be achieved by suitable division of the sub-groups. Thus according to the invention there may be provided a filter as described in the penultimate paragraph in which said stopband is centred on a first predetermined frequency, in which each sub-group is a primary sub-group consisting of at least two secondary sub-groups, each secondary sub-group consisting of strips from both arrays, in which the at least two secondary sub-groups of each primary sub-group are separated by different distances along the first and second tracks, and in which the composition of said secondary sub-groups and their separation along the first and second tracks are selected to provide a further stopband in the amplitude-frequency response of the coupling means and hence in the amplitude-frequency response of the filter centred on a second predetermined frequency.

Surface acoustic wave bandpass electrical filters are known, for example, from an article by L. P. Solie in Applied Physics Letters, Vol. 30, No. 8, 15 April 1977, in which the strips of a multistrip array are arranged in weighted groups spaced along the input and output tracks of the coupler by respective distances which differ by the acoustic wavelength of the centre frequency of the fundamental passband, so as to provide a shaped passband amplitude-frequency response for the multistrip array. The invention is applicable to this type of device, and so according to the invention there may be provided a filter as described in the ante-penultimate paragraph in which there is more than one said group, the composition and relative arrangement of said groups being selected to provide an amplitude-frequency response of the coupling means having a fundamental and some harmonically repeated passbands of predetermined shape, and in which said stopband is centred on a predetermined frequency such that a selected said passband of the coupling means is suppressed.

In devices according to the invention the acoustic waves which the substrate is able to propagate at a surface thereof may be conventional surface acoustic waves propagating in the surface of the substrate.

The acoustic waves may otherwise be, for example, bulk acoustic waves propagating parallel and close to that surface of the substrate; the possible use of this type of bulk acoustic wave is mentioned in connection with delay line feedback oscillators in U.K. Patent Specification No. 1,451,326 and a range of rotated Y-cuts of quartz with propagation perpendicular to the X-axis suitable for this purpose is described in Electronics Letters, 3rd March 1977, Vol 13, No. 5 at pages 128 to 130. The acoustic waves may also otherwise be, for example, piezoelectric leaky surface waves propagating along the X axis of a 41° or 64° rotated Y-cut plane of lithium niobate as described in an article by K. Yamanouchi and K. Shibayama in Journal of Applied Physics, Vol. 43, No. 3, March 1972 at pages 856 to 862.

The invention will now be described in more detail with reference to the accompanying drawings, in which:—

Figure 1 shows schematically in plan view a known surface acoustic wave bandpass electrical filter incorporating double electrode input and output interdigital transducers with an interposed conventional track changing multistrip coupler,

Figure 2 shows the filter of Figure 1 with a modified multistrip coupler according to the invention for providing a stopband centred on a first frequency,

Figure 3 shows a predicted amplitude-frequency response of an example of a multistrip coupler as shown in Figure 2,

Figure 4 shows the measured amplitude-frequency response of an example of a surface acoustic wave filter of the type shown in Figure 2 and including the multistrip coupler whose response is shown in Figure 3,

Figure 5 shows the filter of Figure 1 with another modified multistrip coupler according to the invention for providing a stopband centred on a first frequency,

Figure 6 shows three amplitude-frequency response curves comparing devices according to the configurations shown in Figures 1, 2 and 5,

Figure 7 shows a schematic plan view of another multistrip coupler for use in a device according to the invention, which coupler is further divided with respect to the coupler shown in Figure 2 so as to provide stopbands centred on both said first frequency and a second different frequency, and

Figure 8 shows a schematic plan view of yet another multistrip coupler for use in a device according to the invention, the strips of the coupler being arranged in groups to provide a shaped passband amplitude-frequency response of the coupler and in which each group is split to provide suppression of a selected harmonic passband of the coupler.

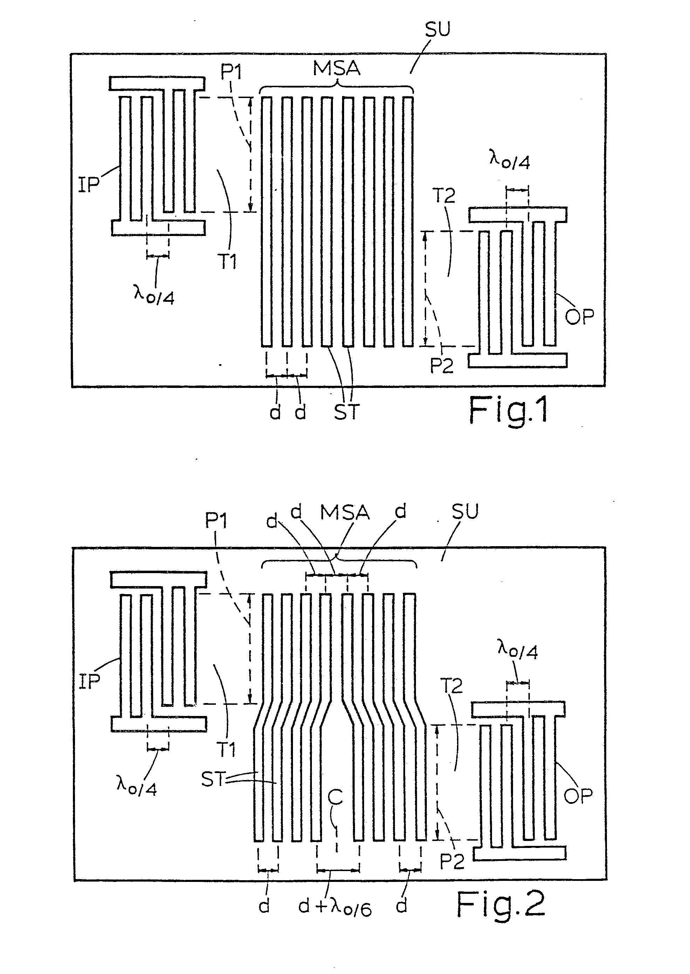

Referring now to Figure 1 there is shown a substrate SU able to propagate surface acoustic waves at a surface thereof, input transducing means IP arranged to launch surface acoustic wave energy along a first propagation track T1 at the surface, output transducing means OP arranged to receive surface acoustic wave energy from a second propagation track T2 at the surface and electrical coupling means MSA arranged to receive surface acoustic wave energy from the input transducing means IP in the first track T1 via an input port P1 and to relaunch at least part of that energy as surface acoustic wave energy towards the output transducing means OP in the second track T2 via an output port P2.

The input transducing means IP and the output transducing means OP are both interdigital transducers comprising double electrodes, that is to say having electrodes with a centre-to-centre separation period of a quarter wavelength $\lambda_0/4$ of surface acoustic waves at the centre frequency $f_0$ of a fundamental passband of the amplitude-frequency response of the transducer, and the mark-to-space ratio of the electrodes of the transducers is one-to-one. The combined amplitude-frequency response of the transducers IP and OP has harmonically repeated passbands of predetermined shape, including a fundamental passband centred at the frequency $f_0$ which is substantially the desired passband of the electrical filter formed by the device and a third harmonic passband at a frequency $3f_0$ which is of nearly equal amplitude to that of the fundamental passband.

The electrical coupling means MSA consists of an array of a number N of discrete parallel conducting strips ST electrically insulated from each other. Each strip ST may be considered as a pair of strips in which one strip of the pair is part of an array of strips across the track T1, the other strip of the pair is part of an array of strips across the track T2 and the two strips of each pair are electrically connected.

The array MSA is a conventional track changing multistrip coupler in that the centre-to-centre separation period $d$ between the strips ST is constant for the array of strips in each of the tracks T1 and T2 and is the same in both tracks. The operation of the conventional multistrip coupler has been described in detail in, for example, an article by F. G. Marshall et al. in IEEE Transactions 1973, MTT-21, pages 206 to 215. For the present purpose, its operation may be described simply as follows. Each strip ST may be considered as partially transferring the input signal from track T1 to track T2 with a constant phase shift. The total power transferred is a sine squared function of the number of strips N due to interactions within the coupler. The path length between the input port P1 and the output port P2 is constant for transfer via any strip ST. This means that the signals transferred by each strip ST add in phase over a very wide range of frequencies and hence the amplitude-frequency response of the conventional multistrip coupler is a very broad passband. This behaviour is modified in the immediate vicinity of the well known stopband frequency $f_s$ which is the frequency at which the strip period $d$ is half a wavelength of surface acoustic waves and at harmonics of the frequency $f_s$. In general, when a conventional multistrip coupler is designed to track change a signal at a frequency $f_0$ (usually $f_0 < f_s$) the coupler also transmits harmonics of $f_0$ (except in the region of the just-mentioned stopband harmonics). Thus in the known surface acoustic wave bandpass electrical filter shown in Figure 1 the third harmonic passband at the frequency $3f_0$ is transmitted and input signals within that passband are present in the filter output.

Referring now to Figure 2, there is shown the filter of Figure 1 with a modified multistrip coupler according to the invention. The group of N strips ST of the coupler MSA is now split with respect to a centre of symmetry C into two sub-groups each consisting of N/2 strips, and the two sub-groups are separated by different distances $d$ and $(d + \lambda_0/6)$ along the tracks T1 and T2 respectively. Surface acoustic wave energy received by the coupler MSA via the input port P1 from the input transducer IP at the frequency $3f_0$ is relaunched at that frequency via the output port P2 with equal magnitude but in antiphase by the two sub-groups of the coupler MSA so that surface acoustic wave energy at the frequency $3f_0$ is not received by the output transducer OP.

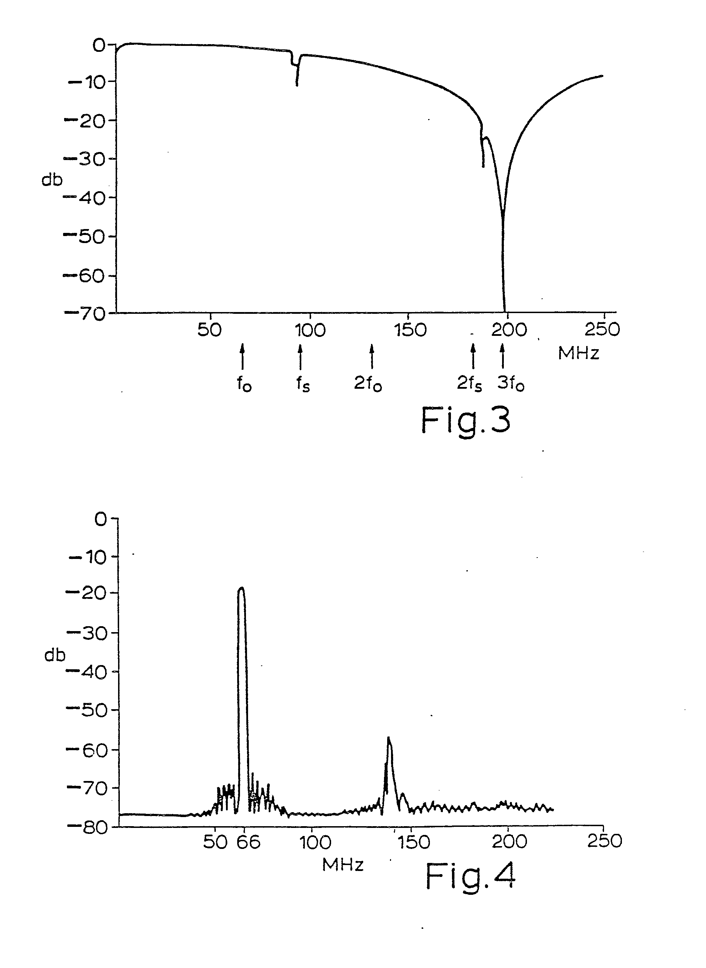

An analysis technique for the investigation of the frequency response of a multistrip array is described in an article by M. Feldmann and J. Henaff in the Proceedings of the IEEE Ultrasonics Symposium 1977 at pages 686 to 690. This analysis has been applied to a multistrip array as shown in Figure 2 in which the strip period $d$ is $0.35\lambda_0$ with mark-to-space ratio one-to-one, the total number of strips N is 108 and the assumed piezoelectric coupling constant $k^2$ is 0.047 (for a Y—Z lithium niobate substrate). The predicted amplitude-frequency transmission response of this multistrip array is shown in Figure 3 which is scaled for $f_0 = 66$ MHz. A stopband in the response centred on the frequency $3f_0$ is apparent; in the case shown where $3f_0$ is 198 MHz the response is −30 db over a bandwidth of 8 MHz centred on 198 MHz. The suppression centred on $3f_0$ is achieved at the expense of a small transmission loss at $f_0$ of 1.25 db. The stopbands at

$f_s = 1.43f_0$ and at $2f_s$ are also in evidence.

A more rigorous analysis technique for a multistrip array has been described in a paper given by two of the present inventors at the IEEE Ultrasonics Symposium, November 1980. This analysis takes into account the wideband frequency response of a single strip and modifies the response shown in Figure 3 to an overall passband having a null at zero frequency and at $4f_0$; however, the stopbands at $f_s$, $2f_s$ and $3f_0$ are present essentially as shown in Figure 3.

A surface acoustic wave filter of the type shown in Figure 2, that is to say having double electrode input and output transducers with a fundamental frequency $f_0 = 66$ MHz and a multistrip array as described in the previous paragraph on Y—Z lithium niobate has been made and the practical untuned frequency response of this filter measured with 50 ohm source and load impedances is shown in Figure 4. The combined amplitude-frequency response of the input and output transducers has harmonically repeated passbands including a fundamental passband at $f_0$ (the bandwidth being 5 MHz centred on 66 MHz at 30 db down from the peak of the passband) and a corresponding passband of nearly equal amplitude at $3f_0$. The filter response shown in Figure 4 shows that the passband reponse at $3f_0$ (198 MHz) has been completely suppressed. The response seen at 140 MHz is due to residual bulk waves.

Referring back to Figure 2 the different $\lambda_0/6$ in the separation between the two sub-groups of the multistrip array along the tracks T1 and T2 respectively may be expressed as $\lambda_0/2n$ where $n = 3$. A signal input at the input port P1 of the array results in two output signals at the output port P2 which have a relative phase difference $\emptyset°$ at a frequency $f$ defined by the equation $\emptyset = 180$ $f/nf_0$ degrees. Thus at a frequency $f = nf_0$ the two signals have a phase difference of 180° and interfere destructively. Where $n = 3$, a signal input at a frequency $3f_0$ will be suppressed; where $n$ is another integer a corresponding other $n$th harmonic of the frequency $f_0$ will be suppressed; if $n$ is not an integral number another frequency which is not a harmonic of $f_0$ may be chosen for suppression; furthermore whatever value is chosen for $n$ there will also be suppression at odd harmonics of the frequency $nf_0$, for example where $n = 3$ there will be suppression at $3f_0$, $9f_0$, $15f_0$, $21f_0$ etc.

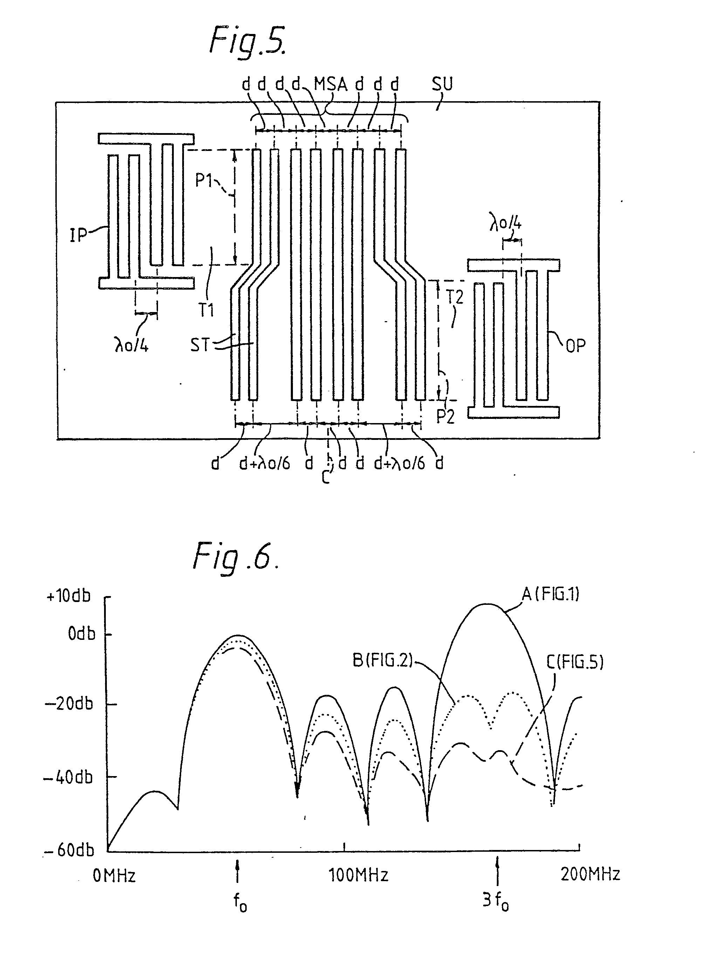

Referring now to Figure 5, there is shown the filter of Figure 1 with another modified multistrip coupler according to the invention. The group of N strips ST of the coupler MSA is now split with respect to a centre of symmetry C into three subgroups with a centre sub-group consisting of N/2 strips and two outer sub-groups each consisting of N/4 strips, and the three sub-groups are separated by different distances $d$ and $(d + \lambda_0/6)$ along the tracks T1 and T2 respectively. Surface acoustic wave energy received by the coupler MSA via the input port P1 from the input transducer IP at the frequency $3f_0$ is relaunched at that frequency via the output port P2 by the two outer sub-groups with a combined magnitude equal to but in antiphase with the energy from the centre sub-group of the coupler MSA so that surface acoustic wave energy at the frequency $3f_0$ is not received by the output transducer OP. Both the width and in practice the depth of the stopband in the amplitude-frequency response of the coupler MSA centred on the frequency $3f_0$ are greater than that for the corresponding stopband of the multistrip array shown in Figure 2, although this improvement is at the expense of a small additional transmission loss at $f_0$.

Referring now to Figure 6 there are shown three measured amplitude-frequency response curves. The full line curve A shows the response of a device having the configuration shown in Figure 1, the dotted line curve B shows the response of a device having the configuration shown in Figure 2 and the dashed line curve C shows the response of a device having the configuration shown in Figure 5. The three devices were all made on a rotated Y-cut X-propagating lithium niobate substrate so that the 3rd harmonic response of the transducers would not be obscured by bulk waves. The input and output transducers IP and OP were the same in all three devices, that is to say double electrode transducers with a fundamental frequency $f_0 = 55$ MHz and a wide fundamental passband of 50 MHz (null-to-null) so that the suppression properties of the multistrip coupler MSA is demonstrated within the equally wide third harmonic passband. In a practical filter the transducers would be such that the fundamental and third harmonic passbands are very much narrower, for example 10 MHz (null-to-null). The multistrip coupler consists of one hundred strips in all three devices. Curve A shows that the third harmonic response in the configuration of Figure 1 is 10 db above the fundamental response which is due to better matching to the 50 ohm source and load impedances. Curves B and C show the above discussed small loss at the fundamental frequency $f_0$ and the stopband suppression around the third harmonic frequency $3f_0$ which is deeper and wider for the Figure 5 configuration than for the Figure 2 configuration.

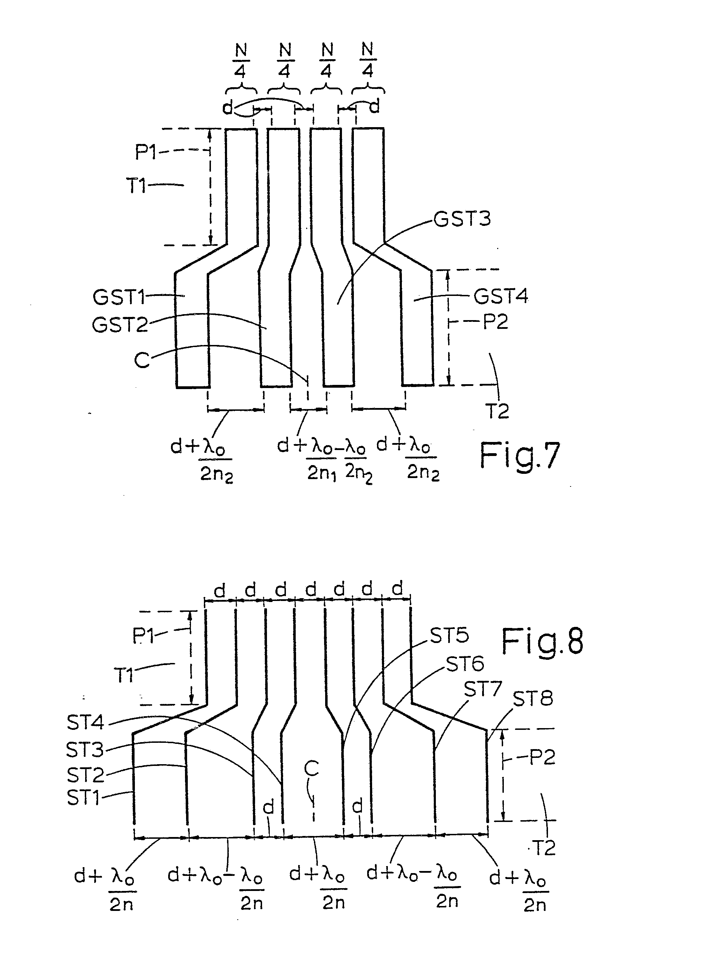

Referring now to Figure 7, there is shown a schematic plan view of another multistrip array for use in a device according to the invention, which array is further divided with respect to the multistrip array shown in Figure 2 so as to provide stopband suppression centred on two different frequencies. In Figure 7 a group of N strips is divided into two primary sub-groups, and each primary sub-group consists of a corresponding pair of secondary sub-groups, namely the pair formed by secondary sub-groups GST1 and GST2 and the pair formed by secondary sub-groups GST3 and GST4. The four sub-groups of strips GST1, GST2, GST3 and GST4 each consist of N/4 strips where N is the total number of strips in the array; all four sub-groups are separated by the same distance $d$ in the track T1; the sub-groups GST2 and GST3 are separated by a distance

$d + \lambda_0/2n_1 - \lambda_0/2n_2$ in the track T2; the pair of secondary sub-groups GST1 and GST2 are separated by a distance $d + \lambda_0/2n_2$ in the track T2; and the pair of secondary sub-groups GST3 and GST4 are also separated by the distance $d + \lambda_0/2n_2$ in the track T2. An input signal received by the multistrip array at a frequency $n_1f_0$ at the input port P1 in the track T1 results in a first signal at the output port P2 due to one primary sub-group formed by the pair of secondary sub-groups GST1 and GST2 which interferes destructively with a second signal at the output port P2 in the track T2 due to the other primary sub-group formed by the pair of secondary sub-groups GST3 and GST4 at the frequency $n_1f_0$. An input signal received by the multistrip array at a frequency $n_2f_0$ different from the frequency $n_1f_0$ at the input port P1 results in a first signal at the output port P2 due to the secondary sub-group GST1 which interferes destructively with a second signal at the output port P2 due to the corresponding other secondary sub-group GST2 at the frequency $n_2f_0$ and also results in a third signal at the output port P2 due to the secondary sub-group GST3 which interferes destructively with a fourth signal at the output port P2 due to the corresponding other secondary sub-group GST4 at the frequency $n_2f_0$. Thus stopbands centred on the two different frequencies $n_1f_0$ and $n_2f_0$ are both provided by the multistrip array. Further sub-division of each of the secondary sub-groups GST1 to GST4 could be provided for stopbands centred at further different frequencies.

Referring now to Figure 8, there is shown a schematic plan view of another multistrip array for use in a device according to the invention, the strips of the array being arranged in groups to provide a shaped passband amplitude-frequency response of the array and in which each group is split to provide suppression of a selected harmonic passband of the coupler. The array consists of a first group of two strips ST1 and ST2, a second group of four strips ST3, ST4, ST5 and ST6, and a third group of two strips ST7 and ST8, and has a centre of symmetry C. In the track T1 all the strips are separated by the same distance $d$. In the track T2, the strips ST1 to ST8 are separated by successive distances $d + \lambda_0/2n$, $d + \lambda_0 - \lambda_0/2n$, $d$, $d + \lambda_0/2n$, $d$, $d + \lambda_0 - \lambda_0/2n$ and $d + \lambda_0/2n$.

The arrangement of the strips of the array into three groups of two, four and two strips respectively with a centre-to-centre separation between the groups of $3d$ in track T1 and $3d + \lambda_0$ in track T2 provides an amplitude-frequency response of the array having harmonically repeated shaped passbands including a fundamental passband centred on the frequency $f_0$. An input signal received by the multistrip array at a frequency $nf_0$ at the input port P1 in the track T1 results in a first signal at the output port P2 in the track T2 due to the strip ST1 which interferes destructively with a second signal at the output port P2 due to the strip ST2 at the frequency $nf_0$; the same input signal results in a third signal due to the strips ST3 and ST4 which interferes destructively with a fourth signal due to the strips ST5 and ST6 at the output port P2 at the frequency $nf_0$; and the same input signal results in a fifth signal due to the strip ST7 which interferes destructively with a sixth signal due to the strip ST8 at the output port P2 at the frequency $nf_0$. The signal at $nf_0$ is thus suppressed by the multistrip array. Signals over a range of frequencies centred on $nf_0$ will also be suppressed and so the array may be arranged for suppression of a selected one of its harmonic passbands, for example the third harmonic passband at $3f_0$ when $n = 3$.

Further possible variations within the scope of the invention are as follows.

If the interdigital transducers IP and OP shown in Figures 2 and 5 have electrodes with a centre-to-centre separation period of a half wavelength $\lambda_0/2$ of surface acoustic waves at the centre frequency $f_0$ of the fundamental passband, known as a single electrode transducer, and have an electrode mark-to-space ratio of one-to-one; then the nearest further passband to the fundamental passband is a fifth harmonic passband response at a frequency $5f_0$. An advantage of the single electrode configuration transducer is that for a given minimum realisable width of the electrodes the fundamental passband is at twice the frequency of a double electrode configuration transducer. However, the unsuppressed fifth harmonic response resulting from this use may be a significant disadvantage in certain filter applications. The composition and separation of the sub-groups of strips of the multistrip coupler MSA may then be chosen to provide a stopband in the amplitude-frequency response of the coupler centred on the frequency $5f_0$; in the configurations shown in Figure 2 and Figure 5 this may be achieved by the difference in the separation between the sub-groups along the tracks T1 and T2 being $\lambda_0/10$.

The composition and separation of the three sub-groups of the coupler MSA may be varied. For example, if the three sub-groups have an equal number of strips and are separated by different distances $d$ and $(d + \lambda_0/9)$ along the tracks T1 and T2 respectively there will again be a stopband in the amplitude-frequency response of the coupler MSA centred on the third harmonic frequency $3f_0$, and the depth and width of this stopband will be between those of the stopbands at $3f_0$ of the couplers MSA shown in Figures 2 and 5.

It would be possible to divide the multistrip coupler MSA into more than three, for example five or seven, sub-groups in order to provide a stopband in the amplitude-frequency response of the coupler for suppression of an undesired passband of the combined amplitude-frequency response of the input and output transducers. However this would be at the expense of increased insertion loss of the filter at the fundamental frequency.

In the above description filters have been discussed in which a stopband in the amplitude-frequency response of the multistrip coupler MSA suppresses an undesired odd harmonic passband in the combined amplitude-frequency response of the input and output transducers which has a desired fundamental frequency passband. The desired passband may be other than the fundamental frequency passband. Thus in more general terms in accordance with the invention, the combined amplitude-frequency response of the input and output transducers has a first passband which is substantially the desired passband of the filter and further passbands having a harmonic relationship with said first passband, and a stopband is provided in the amplitude-frequency response of the multistrip coupler which suppresses a selected said further passband.

The above-mentioned article by M. Feldmann and J. Henaff in the Proceedings of the IEEE Ultrasonics Symposium 1977 at pages 686 to 690 mentions two types of multistrip array, that is to say a transmitting array (MTA) and a reflecting array (MRA). The geometry of multistrip reflecting arrays is not suitable for adaptation within the scope of the present invention.

## Claims

1. An acoustic wave bandpass electrical filter including a substrate able to propagate acoustic waves at a surface thereof, input transducing means arranged to launch acoustic wave energy along a first propagation track at said surface, output transducing means arranged to receive acoustic wave energy from a second propagation track at said surface, and electrical coupling means arranged to receive acoustic wave energy from the input transducing means in the first track and to relaunch at least part of that energy as acoustic wave energy towards the output transducing means in the second track, in which the combined amplitude-frequency response of the input and output transducing means has a first passband which is substantially the desired main passband of the filter and at least one undesired passband at a respective odd harmonic frequency with respect to said first passband, and in which the coupling means consists of an array of conducting strips across the first track and an array of conducting strips across the second track, the conducting strips of each array being discrete parallel strips electrically insulated from each other end strips of the two arrays being electrically connected in pairs with each pair consisting of one strip from each array, the strips of the coupling means being arranged in one group or in a plurality of groups so that, for example, adjacent said groups are spaced from one another along the first and second tracks by respective distances which differ by $\lambda_0$, where $\lambda_0$ is the acoustic wavelength of the centre frequency $f_0$ of the desired first passband, characterised in that the or each group consists of a corresponding set of at least two subgroups, each subgroup consisting of strips from both arrays, and in that for each set, the respective effective adjacent sub-group spacings along the first and second tracks differ by an amount which is substantially less than $\lambda_0$ and is a proper fraction of the acoustic wavelength of a predetermined frequency which substantially coincides with the centre frequency of a selected said undesired further passband, and the number and relative composition of the sub-groups forming the set are selected in relation to said proper fraction so as to cause the acoustic wave energy relaunched thereby towards the output transducer to combine in a mutually cancelling phase and amplitude relationship at said predetermined frequency so as to provide a stopband in the amplitude-frequency response of the coupling means which suppresses said selected undesired further passband while maintaining the desired main passband response of the filter.

2. A filter as claimed in Claim 1, in which the or each said group consists of two sub-groups.

3. A filter as claimed in Claim 1, in which the or each said group consists of three sub-groups.

4. A filter as claimed in any one of Claims 1 to 3, in which said first passband is a fundamental passband and the nearest said further passband is a corresponding third harmonic passband, and in which the selected said further passband which is suppressed is said third harmonic passband.

5. A filter as claimed in any one of Claims 1 to 3, in which said first passband is a fundamental passband and the nearest said further passband is a corresponding fifth harmonic passband, and in which the selected said further passband which is suppressed is said fifth harmonic passband.

6. A filter as claimed in Claim 1, in which said stopband is centred on a first predetermined frequency, in which each sub-group is a primary sub-group consisting of at least two secondary sub-groups, each secondary sub-group consisting of strips from both arrays, in which the at least two secondary sub-groups of each primary sub-group are separated by different distances along the first and second tracks, and in which the composition of said secondary sub-groups and their separation along the first and second tracks are selected to provide a further stopband in the amplitude-frequency response of the coupling means and hence in the amplitude-frequency response of the input and output transducing means centred on a second predetermined frequency.

7. A filter as claimed in Claim 1, in which there is one said group, the composition and relative arrangement of said groups being selected to provide an amplitude-frequency response of the coupling means having a fundamental and some harmonically repeated passbands of predetermined shape, and in which said stopband is centred on a predetermined frequency such that a selected said passband of the coupling means is suppressed.

## Patentansprüche

1. Elektrisches Bandpassfilter für akustische Oberflächenwellen mit einem Substrat zum Fortpflanzen akustischer Wellen auf einer Substratoberfläche, mit einem Eingangswandler zum Eingeben akustischer Wellenenergie in einen ersten Fortpflanzungsweg auf der Substratoberfläche, mit einem Ausgangswandler zum Empfangen akustischer Wellenenergie aus einem zweiten Fortpflanzungsweg auf der Substratoberfläche und mit einer elektrischen Verbindung zum Empfangen akusterischer Wellenenergie aus dem Eingangswandler über den ersten Weg und zum Weiterleiten zumindest eines Teiles dieser Energie als akustische Wellenenergie zum Ausgangswandler über den zweiten Weg, wobei der kombinierte Amplitudenfrequenzgang des Eingangs- und Ausgangswandlers einen ersten Durchlassbereich, der im wesentlichen der der verlangte Hauptedurchlassbereich des Filters ist, und zumindest einen ungewünschten Durchlassbereich auf einer jeweiligen, ungeradzahligen harmonischen Frequenz in bezug auf den ersten Durchlassbereich aufweist, und wobei die Verbindung aus einer Reihe leitender Streifen über den ersten Weg und aus einer Reihe leitender Streifen über den zweiten Weg besteht, wobei die leitenden Streifen jeder Reihe diskrete parallele, elektrisch voneinander isolierte Streifen sind und Streifen der beiden Reihen paarweise elektrisch miteinander verbunden sind, wobei jedes Paar aus je einem Streifen jeder Reihe besteht, wobei die Streifen der Verbindung in einer Gruppe oder in einer Anzahl von Gruppen so angeordnet sind, dass beispielsweise benachbarte Gruppen entlang der ersten und zweiten Wege mit jeweiligen Abständen voneinander getrennt sind, die um $\lambda_0$ verschieden sind, worin $\lambda_0$ die akustische Wellenlänge der zentralen Frequenz $f_0$ des verlangten ersten Durchlassbereichs ist, dadurch gekennzeichnet, dass die Gruppe oder jede Gruppe aus einem entsprechenden Satz von zumindest zwei Untergruppen besteht, wobei jede Untergruppe aus Streifen beider Reihen besteht, und dass für jeden Satz die jeweiligen wirksamen Abstände benachbarter Untergruppen entlang der ersten und zweiten Wege um einen Betrag verschieden sind, der wesentlich kleiner als $\lambda_0$ und ein geeigneter Bruchteil der akustischen Wellenlänge einer vorgebenen Frequenz ist, die im wesentlichen mit der zentralen Frequenz eines ausgewählten, ungewünschten weiteren Durchlassbereichs zusammenfällt, und die Zahl und jeweilige Zusammensetzung der den Satz bildenden Untergruppen derart in Zusammenhang mit dem geeigneten Bruchteil ausgewählt sind, dass die akustische Wellenenergie, die Sie zum Ausgangswandler weiterleiten, sich in einem zur gegenseitigen Aufhebung führenden Phasen- und Amplituden-Zusammenhang bei der vorgegebenen Frequenz kombiniert und so einen Sperrbereich im Amplituden-Frequenzgang der Verbindung bildet, der den ausgewählten, ungewünschten weiteren Durchlassbereich unter Beibehaltung des verlangten Hauptdurchlassbereiches des Filters unterdrückt.

2. Filter nach Anspruch 1, dadurch gekennzeichnet, dass die oder jede Gruppe aus zwei Untergruppen besteht.

3. Filter nach Anspruch 1, dadurch gekennzeichnet, dass die oder jede Gruppe aus drei Untergruppen besteht.

4. Filter nach einem der Ansprüche 1 bis 3, dadurch gekennzeichnet, dass der erste Durchlassbereich ein Grunddurchlassbereich und der am nächsten liegende weitere Durchlassbereich ein entsprechender 3. Harmonischen-Durchlassbereich ist, und dass der ausgewählte weitere Durchlassbereich, der unterdrückt wird, der 3. Harmonischen-Durchlassbereich ist.

5. Filter nach einem der Ansprüche 1 bis 3, dadurch gekennzeichnet, dass der erste Durchlassbereich ein grunddurchlassbereich und der am nächsten liegende weitere Durchlassbereich ein entsprechender 5. Harmonischen-Durchlassbereich ist, und dass der ausgewählte weitere Durchlassbereich, der unterdrückt wird, der 5. Harmonischen-Durchlassbereich ist.

6. Filter nach Anspruch 1, dadurch gekennzeichnet, dass der Sperrbereich auf einer ersten vorgegebenen Frequenz zentriert ist, in der jede Untergruppe eine primäre Untergruppe ist, die aus zumindest zwei sekundären Untergruppen aufgebaut ist, wobei jede sekundäre Untergruppe aus Streifen beider Reihen besteht, wobei die zumindest zwei sekundären Untergruppen jeder primären Untergruppe in verschliedenen Abständen entlang der ersten und der zweiten Wege voneinander getrennt sid, und dass die Zusammensetzung der sekundären Untergruppe und ihre Trennung entlang der ersten und zweiten Wege zur Bilding eines weiteren Sperrbereichs im Amplituden-Frequenzgang der Verbindung und daher im Amplituden-Frequenzgang des Eingangs- und Ausgangswandlers in einer Zentrierung auf einer zweiten vorgegebenen Frequenz ausgewählt sind.

7. Filter nach Anspruch 1, dadurch gekennzeichnet, dass es eine derartige Gruppe gibt, wobei die Zusammensetzung und die jeweilige Anordnung der genannten Gruppen zur Bildung eines Amplituden-Frequenzgangs der Verbindung mit einem Grunddurchlassbereich und einige harmonisch wiederholte Durchlassbereiche vorgebener Form ausgewählt sind, und dass der Sperrbereich auf einer vorgegebenen Frequenz derart zentriert ist, dass ein ausgewählter Durchlassbereich der Verbindung unterdrückt wird.

## Revendications

1. Filtre électrique passe-bande à ondes acoustiques de surface comportant un substrat capable de propager des ondes acoustiques à une surface de celui-ci, un transducteur d'entrée servant à émettre de l'énergie d'ondes acoustiques le long d'une première piste de propagation à ladite surface, un transducteur de sortie servant à recevoir de l'énergie d'ondes acoustiques à partir d'une seconde piste de propagation à ladite surface et des moyens de couplage électrique servant à recevoir de l'énergie d'ondes acoustiques à partir du transducteur d'entrée dans la première piste et à réémettre au moins une partie de cette énergie sous la forme d'énergie d'ondes acoustiques vers le transducteur de sortie dans la seconde piste, filtre dans lequel la réponse combinée en amplitude-fréquence des transducteurs d'entrée et de sortie présente, d'une part, une première bande passante qui constitue sensiblement la bande passante principale souhaitée du filtre et, d'autre part, au moins une bande passante inopportune à une fréquence harmonique impaire respective par rapport à ladite première bande passante, alors que les moyens de couplage sont constitués par un réseau de bandes conductrices situé sur la première piste et un réseau de bandes conductrices situé sur la seconde piste, les bandes conductrices de chaque réseau étant des bandes parallèles discrètes électriquement isolées les unes des autres, et des bandes des deux réseaux étant reliées paire par paire, chaque paire étant constituée par une bande de chaque réseau, les bandes des moyens de couplage étant disposées en un seul groupe ou en une pluralité de groupes, de sorte que, par exemple, les groupes voisins sont séparés le long de la première et de la seconde piste par des distances respectives qui diffèrent de $\lambda_0$, $\lambda_0$ étant la longueur d'onde acoustique de fréquence centrale $f_0$ de la première bande passante souhaitée, caractérisé en ce que le groupe ou chaque groupe est constitué par un jeu correspondant d'au moins deux sous-groupes, chaque sous-groupe étant constitué par des bandes des deux réseaux et en ce que pour chaque jeu, les intervalles effectifs respectifs entre des sous-groupes voisins le long de la première et de la seconde piste diffèrent d'une quantité qui est sensiblement inférieure à $\lambda_0$ et qui est une fraction moindre que l'unité de la longueur d'onde acoustique d'une fréquence prédéterminée coïncidant sensiblement avec la fréquence centrale d'une autre bande passante inopportune, et en ce que le nombre et la constitution relative des sous-groupes formant le jeu sont sélectionnés par rapport à ladite fraction moindre que l'unité de façon que les ondes acoustiques réémises par ceux-ci vers le transducteur de sortie présentent à ladite fréquence prédéterminée une phase et une amplitude telles qu'elles s'annulent, de sorte qu'on obtient dans la réponse amplitude-fréquence des moyens de couplage une bande d'arrêt supprimant ladite autre bande passante inopportune sélectionnée tout en maintenant la réponse de bande passante principale souhaitée du filtre.

2. Filtre selon la revendication 1, caractérisé en ce que ledit groupe ou chacun desdits groupes est constitué par deux sous-groupes.

3. Filtre selon la revendication 1, caractérisé en ce que ledit groupe ou chacun desdits groupes est constitué par trois sous-groupes.

4. Filtre selon l'une quelconque des revendications 1 à 3, caractérisé en ce que ladite première bande passante est une bande passante fondamentale et en ce que l'autre bande passante la plus proche est une bande passante de troisième harmonique correspondante et en ce que cette bande passante de troisième harmonique constitue l'autre bande passante sélectionnée qui est supprimée.

5. Filtre selon l'une quelconque des revendications 1 à 3, caractérisé en ce que ladite première bande passante est une bande passante fondamentale, en ce que l'autre bande passante la plus proche est une bande passante de cinquième harmonique correspondante et en ce que cette bande passante de cinquième harmonique constitue l'autre bande passante sélectionnée qui est supprimée.

6. Filtre selon la revendication 1, caractérisé en ce que ladite bande d'arrêt est centrée sur une première fréquence prédéterminée, en ce que chaque sous-groupe est un sous-groupe principal constitué d'au moins deux sous-groupes secondaires, chaque sous-groupe secondaire étant constitué de bandes des deux réseaux, en ce que lesdits deux sous-groupes secondaires de chaque sous-groupe principal sont séparés par des distances différentes le long de la première et de la seconde piste et en ce que la constitution desdits sous-groupes secondaires et leur séparation le long de la première et de la seconde piste sont sélectionnées de façon que dans la réponse amplitude-fréquence des moyens de couplage et, par conséquent, dans la réponse amplitude-fréquence des transducteurs d'entrée et de sortie, soit obtenue une autre bande d'arrêt centrée sur une seconde fréquence prédéterminée.

7. Filtre selon la revendication 1, caractérisé en ce qu'il est prévu un seul groupe, la constitution et la disposition des groupes les uns par rapport aux autres étant sélectionnées de façon que la réponse amplitude-réponse des moyens de couplage présente une bande passante fondamentale et quelques bandes passantes harmoniquement répétées de forme prédéterminée et en ce que ladite bande d'arrêt est centrée sur une fréquence prédéterminée de telle façon qu'une bande passante sélectionnée des moyens de couplage est supprimée.

Fig.1

Fig.2

1

Fig.3

Fig.4

# Fig.5.

# Fig.6.

Fig.7

Fig.8

4